# EUROPÄISCHE PATENTSCHRIFT

(11) **EP 4 075 155 B1**
(45) Veröffentlichungstag und Bekanntmachung des Hinweises auf die Patenterteilung: **18.12.2024**
(21) Anmeldenummer: 22020170.1
(22) Anmeldetag: 13.04.2022
(51) Int. Cl.: G01R 31/302, G01R 31/315, G06K 7/10

(54) **VERFAHREN UND MESSGERÄT ZUR MATERIALPRÜFUNG EINES KARTENFÖRMIGEN DATENTRÄGERS**
METHOD AND MEASURING DEVICE FOR TESTING THE MATERIAL OF A CARD-SHAPED DATA CARRIER
PROCÉDÉ ET APPAREIL DE MESURE DESTINÉS À L'ESSAI DE MATÉRIAUX D'UNE CARTE DE STOCKAGE DE DONNÉES EN FORME DE CARTE

(30) Priorität: 14.04.2021 DE 102021001965
(43) Veröffentlichungstag der Anmeldung: 19.10.2022
(73) Patentinhaber: Giesecke+Devrient ePayments GmbH, 81677 München (DE)
(72) Erfinder: Baldischweiler, Michael, 81825 München (DE)
(74) Vertreter: Giesecke+Devrient IP

(56) Entgegenhaltungen:
- EP-A2- 2 765 432
- EP-A2- 2 779 031

## Beschreibung

Die Erfindung betrifft ein Verfahren zur Materialprüfung eines kartenförmigen Datenträgers.

Kartenförmige Datenträger, insbesondere Chipkarten, werden in vielen Bereichen eingesetzt, beispielsweise zur Durchführung von Transaktionen des bargeldlosen Zahlungsverkehrs, als Ausweisdokumente oder zum Nachweis von Zugangsberechtigungen. Eine Chipkarte weist einen Kartenkörper und einen in den Kartenkörper eingebetteten integrierten Schaltkreis zum Beispiel in Form eines Chipmoduls mit einem Chip auf. Das Chipmodul wird in eine Kavität oder Modulöffnung des Kartenkörpers eingesetzt.

Im Folgenden werden Chipkarten mit integrierter Spule betrachtet, welche eine berührungslose oder kontaktlose Kommunikation ermöglichen. Beispielsweise können Chipkartencontroller mit RFID-Funktionalität eingesetzt werden. Die Spule bildet mit einem zusätzlichen Kondensator einen Schwingkreis auf dem Chipmodul.

Es können zudem Chipkarten mit Dual Interface (DI)-Funktionalität, bei dem der Kartenkörper der Chipkarte zum Teil oder vollständig aus Metall besteht. Die Funktionsweise einer solchen Karte besteht darin, dass ein Chipmodul verwendet wird, das selbst eine Spule enthält (Coil-On-Module). Diese Spule koppelt auf den metallischen Kartenkörper.

Es lassen sich bestimmte Aufbauten von Materialien nicht zerstörungsfrei hinsichtlich des Aufbaus untersuchen bzw. bestimmen. Eine ID-Karte kann zwar optisch korrekt aussehen, eine Materialbestimmung beziehungsweise Zusammensetzung ist nicht möglich, ohne den Aufbau mechanisch beziehungsweise chemisch zu zerstören.

Die EP 2765432 A2 beschreibt ein Verfahren zum Prüfen eines Schaltkreises mit induktiv koppelnder Antenne für ein Endgerät mit den folgenden Schritten: Der Schaltkreis wird mittels eines Energiepulses zur Schwingung angeregt. In einem weiteren Schritt wird die Schwingung des Schaltkreises in Antwort auf die Anregung des Schaltkreises durch den Energiepuls erfasst. Die erfasste Schwingung des Schaltkreises wird schließlich ausgewertet, insbesondere hinsichtlich einer Eigenresonanzfrequenz des Schaltkreises. Bevorzugt kann der Schritt des Auswertens der erfassten Schwingung in Abhängigkeit einer Feldstärke (H) erfolgen, in der sich der Schaltkreis befindet. Dazu können die Schritte des Erzeugen eines magnetischen Wechselfeldes vorgegebener Feldstärke (H) und des Anordnens des Schaltkreises in dem Wechselfeld dem Schritt des Anregens des Schaltkreises vorgeschaltet werden. Das Erfassen der Schwingung des Schaltkreises kann mittels einer Breitband-Messantenne erfolgen.

Die EP 2779031 A2 beschreibt ein Verfahren zum Messen einer Eigenschaft eines zur kontaktlosen Datenkommunikation vorgesehenen Schwingkreises und eine entsprechende Messvorrichtung. Die Messvorrichtung wird zu dem Schwingkreis hingeführt. Der Schwingkreis wird durch die Messvorrichtung mittels eines Energiepulses angeregt und eine abklingende Schwingung des Schwingkreises in Antwort auf die Anregung durch den Energiepuls wird mit der Messvorrichtung erfasst. Die Messvorrichtung umfasst hierzu einen Griff für die Führung der Messvorrichtung, eine Erregerantenne für den anregenden Energiepuls und eine Messantenne für das Erfassen der abklingenden Schwingung.

Aufgabe der vorliegenden Erfindung ist es daher, die Kontrolle eines kartenförmigen Datenträgers zu verbessern.

Diese Aufgabe wird durch ein Verfahren zur Materialprüfung eines kartenförmigen Datenträgers gemäß dem unabhängigen Patentanspruch gelöst. Ausgestaltungen und Weiterbildungen der Erfindung sind in den abhängigen Ansprüchen angegeben.

Ein erfindungsgemäßes Verfahren zur Materialprüfung eines kartenförmigen Datenträgers, umfassend die Schritte:
Anordnen eines Referenz-Schwingkreises aufweisend eine Spule an einem Messkopf eines Impuls-Messgeräts, das zum Aussenden eines Impulses einer elektromagnetischen Schwingung und zum Erfassen einer Schwingungsantwort der Spule in Antwort auf den Impuls eingerichtet ist;
Relatives Bewegen des Referenz- Schwingkreises zu dem Datenträger;
Aussenden eines Impulses, Erfassen einer Schwingungsantwort der Spule in Antwort auf den Impuls und Bestimmen mindestens eines Parameters aus der Schwingungsantwort; und
Ermitteln von Material und/oder einer Zusammensetzung des Datenträgers basierend auf dem mindestens einen bestimmten Parameter.
Ein Grundgedanke der vorliegenden Erfindung besteht darin, unter Zuhilfenahme der relativen Permittivität εᵣ den Aufbau und/oder das Material eines kartenförmigen Datenträgers wie einer Chipkarte, ID-Karte, Reisepass, Folienbeschichtung usw. zu ermitteln. So kann ein Datenträger zerstörungsfrei auf Echtheit oder Unversehrtheit geprüft werden.

Wenn ein derartiges Material, das eine relative Permittivität εᵣ aufweist, vor den Referenz-Schwingkreis gebracht wird, ändert sich dessen Schwingungsantwort auf den Impuls eines Impuls-Messgerätes. Mittels mindestens eines der Parameter wie zum Beispiel Resonanzfrequenz, Güte und Amplitude aus der Schwingungsantwort kann nun ein Material oder ein Aufbau charakterisiert und zerstörungsfrei geprüft werden. Der Parameter kann ein physikalischer Parameter wie zum Beispiel Spannung oder Zeit oder auch ein mathematischer Parameter wie zum Beispiel ein Mittelwert oder ein Integral sein.

Unter einem Schwingkreis wird hier auch ein offener Schwingkreis mit nur einer Spule sowie der parasitären Kapazität (Cₚ), die sich um den Schwingkreis bildet, verstanden. Der Schwingkreis wird durch die parasitäre Kapazität (C_{DuT}) des zu prüfenden Materials beziehungsweise des zu prüfenden Aufbaus beeinflusst. Die Gesamtkapazität des Schwingkreises berechnet sich aus: C_{ges} = Cₚ + C_{DuT}. Dadurch kann die Empfindlichkeit oder Messauflösung gesteigert werden und zwar auf Werte bis im Bereich von unter 1 pF (C_{DuT}), da Cp selbst kleiner 5pF, vorzugsweise kleiner 2pF ist.

Grundsätzlich kann ein Prüfverfahren ein Anregen der zu prüfenden Spule zur Schwingung, ein Erfassen der freien, gedämpften Schwingung der Spule in Antwort auf die Anregung sowie ein Auswerten der erfassten Schwingung umfassen.

Dabei wird der Umstand ausgenutzt, dass das Vorhandensein eines Materials an dem Referenz-Schwingkreis die Resonanzfrequenz, die Güte und auch die Amplitude der Spule beziehungsweise des Schwingkreises ändert.

Als Messgerät kann zum Beispiel ein Dirac-Messsystem (DiraTest^{®}-Messsystem) verwendet werden. Dabei wird der Messkopf so modifiziert, dass zum Beispiel eine Karte mit RFID-Eigenschaft fest unter dem Messkopf angebracht wird. Mittel einer einfachen Referenzkarte wird so eine Messung ermöglicht.

Das hier vorgeschlagene Verfahren hat den Vorteil, dass kartenförmige Datenträger einfach und schnell und vor allem zerstörungsfrei untersucht oder geprüft werden können.

Es kann vorgesehen sein, dass ein Kalibrieren des Referenz- Schwingkreises durch Aussenden eines Impulses, Erfassen einer Schwingungsantwort der Spule in Antwort auf den Impuls und Bestimmen mindestens eines Kalibrierungsparameters aus der Schwingungsantwort vorgenommen wird und dass das Ermitteln des Materials und/ oder der Zusammensetzung des Datenträgers basierend auf dem mindestens einen bestimmten Parameter relativ zu mindestens einem Kalibrierungsparameter erfolgt. Dies erlaubt einen Vergleich von einzelnen Messpunkten jeweils in Bezug auf die einzelnen Messpunkte untereinander. So kann eine relative Abweichung zwischen einzelnen Messpunkten und daraus Rückschlüsse auf Material und/ oder Aufbau eines getesteten Datenträgers ermittelt werden.

Es kann ferner vorgesehen sein, dass ein Ermitteln des Materials und/oder der Zusammensetzung des Datenträgers absolut basierend auf dem mindestens einen bestimmten Parameter und einem angegebenen Material und/oder einer Zusammensetzung des Datenträgers erfolgt. Auf diese Weise können absolute Werte bestimmt werden. So können Angaben zu dem Material und/oder dem Aufbau eines Datenträgers an einem oder mehreren Referenzpunkte gegeben sein. An diesem oder diesen Referenzpunkten erfolgt dann das Kalibrieren. Mittels einer Umrechnung über die Abweichung der Messwerte an den Messpunkten kann dann das Material und/oder der Aufbau eines Datenträgers an allen Messpunkten bestimmt werden.

Es kann ferner vorgesehen sein, dass das Aussenden und das Erfassen kontaktlos erfolgt. Da elektromagnetische Impulse verwendet werden, kann der Datenträger aus einem definierten Abstand, der Messungen vergleichbar macht, gemessen werden. Der Datenträger bleibt somit ohne Kontakt, so dass keine Beeinträchtigung des Datenträgers stattfindet.

Es kann ferner vorgesehen sein, dass die Spule Teil eines RFID-Transponders ist. Bedingt durch die große Verbreitung sind geeignete Messsysteme verfügbar und genaue und vergleichbare Messergebnisse zu erzielen.

Es kann vorgesehen sein, dass der Referenz-Schwingkreis eine Spule, einen Kondensator und einen Widerstand aufweist. So kann ein definierter Schwingkreis geschaffen werden, was die Vergleichbarkeit von Messungen vereinfachen kann.

Es kann ferner vorgesehen sein, dass der Referenz-Schwingkreis eine Spule und einen Kondensator einer integrierten Schaltung des Datenträgers aufweist. So kann der Referenz-Schwingkreis als Referenz-Datenträger ausgestaltet sein. So können bei dem Messen beziehungsweise der Materialprüfung oder Qualitätskontrolle identische elektromagnetische Eigenschaften wie auf einem kartenförmigen Datenträger geschaffen werden.

Es kann vorgesehen sein, dass der mindestens eine Parameter aus der Gruppe Resonanzfrequenz, Güte, Amplitude und mittlerer Fehler gewählt wird. Es hat sich experimentell gezeigt, dass diese Parameter einzeln und auch in Kombination gut für eine Charakterisierung des Materials beziehungsweise des kartenförmigen Datenträgers geeignet sind. Mittels des oder der Parameter kann eine Signatur des Materials beziehungsweise des kartenförmigen Datenträgers erzeugt werden, wodurch eine Erkennung und ein Vergleich ermöglicht wird.

Es kann vorgesehen sein, dass die Güte der Spule aus einem Abklingkoeffizienten der Schwingungsantwort ermittelt wird. Aus dem Abklingkoeffizienten δ kann die Güte der Spule oder Antennenspule ermittelt werden. Je länger der Abklingvorgang dauert, desto höher ist die Güte des entsprechenden Schwingkreises. Somit erlaubt eine Auswertung der freien gedämpften Schwingung der Spule, das heißt deren Ausschwingen unmittelbar nach der Anregung, die Güte und auch die Eigenresonanzfrequenz der Spule zu bestimmen.

Ein Messgerät zur Materialprüfung eines kartenförmigen Datenträgers, eingerichtet zum Aussenden eines Impulses einer elektromagnetischen Schwingung und zum Erfassen einer Schwingungsantwort der Spule in Antwort auf den Impuls, umfasst einen Messkopf und einen Referenz-Schwingkreis mit einer Spule, der an dem Messkopf angeordnet ist, wobei der Referenz-Schwingkreis mittels mindestens einer Kapazität trimmbar ist.

Mittels des trimmbaren Referenz-Schwingkreises können bei einer Messung unterschiedliche Frequenzbänder durchfahren werden. So können frequenzabhängige Merkmale der zu testenden Materialien berücksichtigt werden. Dies kann die Genauigkeit und Aussagekraft der Messung erhöhen.

Ansonsten gelten die gleichen Vorteile und Modifikationen wie zuvor beschrieben. Die vorliegende Erfindung wird nachfolgend mit Bezug auf die beiliegenden Zeichnungen beispielhaft beschrieben. Darin zeigen
- Fig. 1:: eine Draufsicht einer Chipkarte;
- Fig. 2:: ein Ersatzschaltbild eines Chipmoduls der Chipkarte mit einem Schwingkreis mit einer inneren Kapazität eines Chips;
- Fig. 3:: ein Ersatzschaltbild eines Chipmoduls der Chipkarte mit einem offenen Schwingkreis;
- Fig. 4:: ein Ersatzschaltbild eines Chipmoduls der Chipkarte mit einem Schwingkreis mit Kondensator, Spule und Widerstand;
- Fig. 5:: eine prinzipielle Darstellung eines Messgeräts zur Materialprüfung eines kartenförmigen Datenträgers wie einer Chipkarte; und
- Fig. 6:: ein Flussdiagramm eines Verfahrens zur Materialprüfung eines kartenförmigen Datenträgers wie einer Chipkarte.

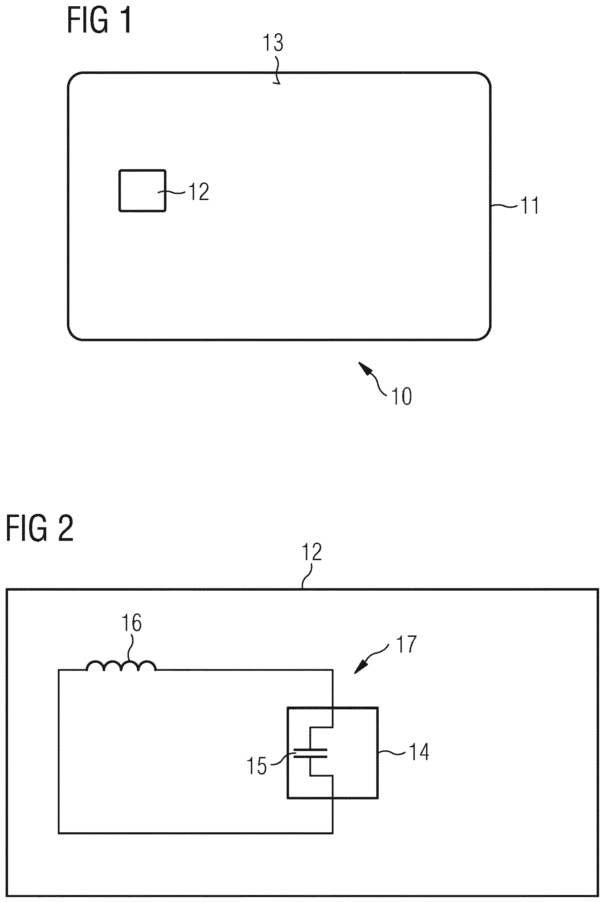

Fig. 1 zeigt als Beispiel für einen kartenförmigen Datenträger eine Chipkarte 10 mit einem Kartenkörper 11. Der Kartenkörper 11 kann aus einem Kunststoff wie PVC, Polycarbonat oder ähnlichem bestehen. Die Dicke des Kartenkörpers 11 kann zum Beispiel zwischen 50 µm und 920 µm betragen.

Die Chipkarte 10 umfasst des Weiteren ein Chipmodul 12, das in eine Hauptfläche 13 des Kartenkörpers 11 oder der Chipkarte 10 eingesetzt ist. Das Chipmodul 12 kann in eine Modulöffnung oder Kavität eingesetzt sein. Die Kavität kann ein mittiges Sackloch und einen umlaufenden Randbereich umfassen. Hier ist die Kavität durch das eingesetzte Chipmodul 12 verdeckt. Das Chipmodul 12 kann in der Kavität verklebt sein.

Das Chipmodul 12 umfasst eine Spule, die auf einem hier nicht dargestellten Modultape angeordnet sein kann. Die Spule kann etwa 12 bis 16 Windungen aufweisen, die hier konzentrisch um einen Chip oder einen elektronischen Schaltkreis des Chipmoduls 12 verlaufen. Die Breite einer Windung kann 50 µm bis 70 µm betragen und der Abstand zwischen zwei Windungen kann 100 µm betragen. Die Windungen können Kupferdicken bis zu etwa 30 µm haben. Mit einer derartigen Spule können maximal 2,5 µH erreicht werden.

Der Chip kann zum Beispiel in Form einer integrierten Schaltung realisiert sein und ist zum Beispiel in einer Vergussmasse an einer Unterseite des Chipmoduls 12 befestigt. Über die Spule wird der Chip mit Energie und/oder Signalen versorgt. So kann ein elektromagnetisches Feld in die Spule eingekoppelt werden. Beispielsweise kann der Chip ein Chipkartencontroller mit RFID-Funktionalität sein oder diesen enthalten.

Fig. 2 zeigt ein Ersatzschaltbild des Chipmoduls 12 der Chipkarte 10. Das Chipmodul 12 umfasst den Chip 14 zum Beispiel in Form einer integrierten Schaltung. Der Chip 14 kann zum Beispiel auf das Chipmodul 12 aufgelötet sein oder per Flip-Chip-Montage auf das Chipmodul 12 aufgebracht worden sein. Der Chip 14 enthält einen Kartencontroller für die Chipkarte 10. Der Chip 14 enthält üblicherweise einen Prozessor zum Ausführen von Steuerungsfunktionen für die Chipkarte 10 und für die Kommunikation und zum Ausführen von Rechenoperationen zum Beispiel für Sicherheitsfunktionen. Zudem enthält der Chip 14 einen Speicherbereich zum Ablegen und/ oder Verfügbarmachen von Daten.

Der Chip 14 enthält ferner einen Kondensator 15 mit einer Kapazität von zum Beispiel 78 pF. Die Spule 16 ist parallel zu dem Chip 14 geschaltet und hat hier eine maximale Induktivität von 2,5 µH.

Die Spule 16 und der Kondensator 15 des Chips 14 bilden einen Schwingkreis 17. Mit Hilfe dieses Schwingkreises 17 kann das Chipmodul 12 mit einem zur Chipkarte 10 externen Lesegerät oder auch einer Messeinrichtung kommunizieren. Das Lesegerät trägt über ein elektromagnetisches Feld Energie in die Spule 16 ein, wodurch der Chip 14 aktiviert wird.

Die Chipkarte 10 kann als Messgerät mit einem Referenz-Schwingkreis 17 verwendet werden. Mit dieser Chipkarte 10 können dann andere Chipkarten oder ähnliches gemessen werden.

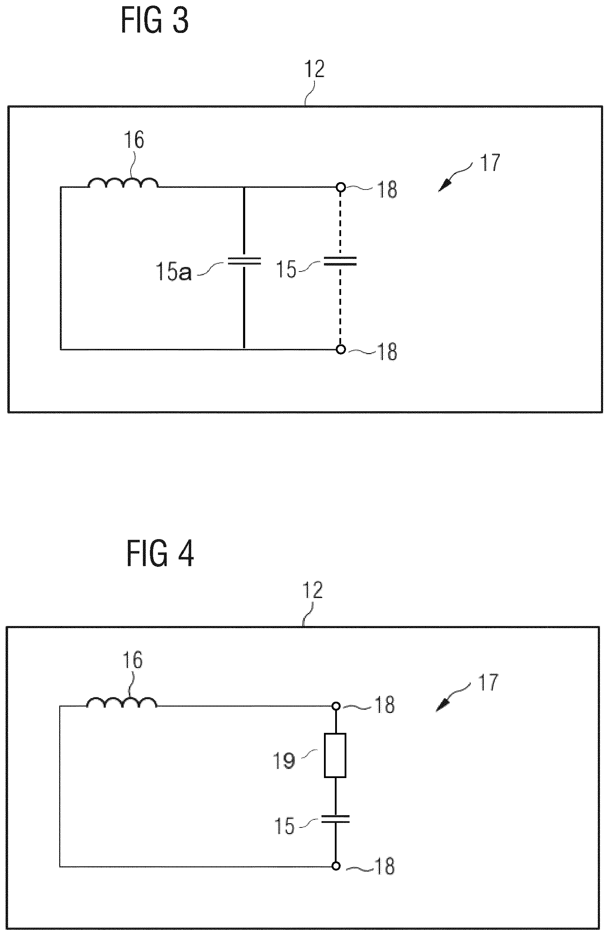

Fig. 3 zeigt ein Ersatzschaltbild eines Chipmoduls 12 der Chipkarte mit einem Referenz-Schwingkreis in Form eines offenen Schwingkreises 17.

Der offene Schwingkreis 17 ist durch die beiden Kontaktpunkte 18 dargestellt. Der hier abgebildete Kondensator 15 entspricht der Kapazität eines zu prüfenden kartenförmigen Datenträgers, wenn dieser an dem Chipmodul 12 beziehungsweise dem Messgerät angeordnet ist. Der Datenträger kann bei dem Messen oder der Materialprüfung beziehungsweise der Qualitätskontrolle direkt an den beiden Kontaktpunkten 18 anliegen oder in kurzem Abstand zu diesen angeordnet sein. Der kurze Abstand liegt im Bereich von Millimetern bis zu einigen Zentimetern.

Eine parasitäre Kapazität 15a ist parallel zu dem Kondensator 15 vorhanden. Diese parasitäre Kapazität 15a bildet sich aus der Spule 16 und aus dem Material in dem sich die Spule 16 befindet. In den in den Figuren 2 und 4 dargestellten Aufbauten ist die parasitäre Kapazität ebenfalls vorhanden, bei den dortigen geschlossenen Schwingkreisen aber vernachlässigbar.

Dieser Aufbau hat je nach Spulendesign eine Resonanzfrequenz zwischen 45 MHz und 75 MHz. Die Frequenz wird hier ausschließlich durch die Induktivität L der Spule 16 und der parasitären Kapazität 15a aus der Spule 16 und dem Materialträger der Spule 16 bestimmt. Je nach Größe der Spule 16 und der Anzahl der Windungen können fast beliebige Frequenzen erreicht werden. Eine Änderung des Kondensators 15 bewirkt eine signifikante Veränderung des Schwingkreises 17. Bei einem solchen Aufbau liegt die Kapazität zum Beispiel zwischen 1 pF bis 3 pF.

Statt eines Chipmoduls 12 kann auch eine Platine oder ein ähnlicher Träger für den Schwingkreis 17 verwendet werden. Dann kann der Formfaktor des Messkopfes kleiner sein.

Fig. 4 zeigt ein Ersatzschaltbild eines Chipmoduls 12 der Chipkarte mit einem Schwingkreis 17 mit Kondensator 15, Spule 16 und Widerstand 19. In diesem Bespiel wird der Schwingkreis 17 ohne das zu prüfende Objekt gebildet. Das zu prüfende Objekt ändert allerdings durch seine Präsenz den Schwingkreis wie zuvor beschrieben wurde.

Statt eines Chipmoduls 12 kann auch eine Platine oder ein ähnlicher Träger für den Schwingkreis 17 verwendet werden. Dann kann der Formfaktor des Messkopfes kleiner sein. Die Kapazität des Kondensators 15 kann in einem Bereich von 1 pF bis etwa 100 pF liegen. Der Wert des Widerstandes 19 kann in einem Bereich von etwa 0 Ohm bis 5 kOhm liegen. Der Schwingkreis 17 kann also auch ohne einen Widerstand aufgebaut sein.

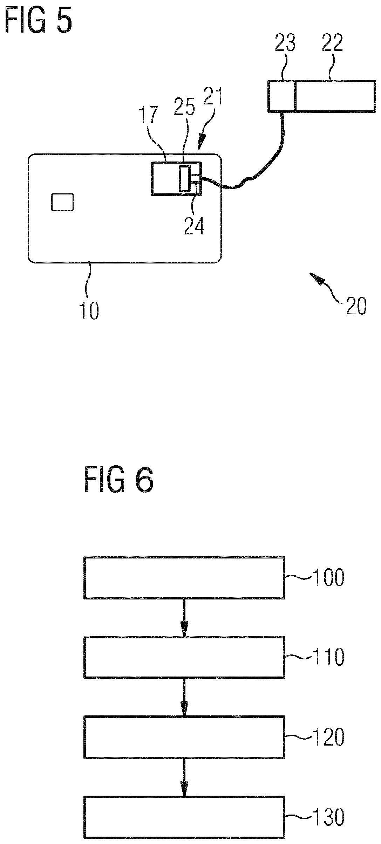

Fig. 5 zeigt eine prinzipielle Darstellung eines Messgeräts 20 zur Materialprüfung einer eines kartenförmigen Datenträgers hier in Form einer Chipkarte 10. Die Chipkarte 10 ist vergrößert dargestellt. Während im Folgenden aus Gründen der Übersicht nur Bezug auf die Chipkarte 10 genommen wird, sind alle kartenförmigen Datenträger umfasst.

Das Messgerät 20 kann ein Impulsmessgerät mit einem Messkopf 21 sein, das zum Aussenden eines Impulses einer elektromagnetischen Schwingung und zum Erfassen einer Schwingungsantwort des Schwingkreises 17 in Antwort auf den Impuls eingerichtet ist.

Der Messkopf 21 oder das Messgerät 20 ist eingerichtet, den Referenz-Schwingkreis 17 zu einer Schwingung anzuregen. Eine Auswertungseinrichtung 22 des Messgeräts 20 ist eingerichtet, eine in Antwort auf die Anregung durch den Messkopf 21 oder das Messgerät 20 erfasste Schwingung des Referenz-Schwingkreises 17 auszuwerten. In Abhängigkeit von dem Material und/oder dem Aufbau wie zum Beispiel einer Schichtenfolge der Chipkarte 10 ändert sich das Schwingungsverhalten des Referenz-Schwingkreises 17.

Mittels einer solchen Auswertungseinrichtung 22 können die Resonanzfrequenz, die Güte und die Amplitude der Schwingungsantwort beziehungsweise der Antennenspule auf einfache und zuverlässige Weise bestimmt werden. Eine Auswertung dieser Parameter lässt dann Rückschlüsse auf das Material und/oder die Zusammensetzung der Chipkarte 10 zu.

Mindestens einer der Parameter Resonanzfrequenz, Güte und Amplitude aus der Schwingungsantwort wird zu einer Charakterisierung der Chipkarte 10 verwendet. Je mehr Parameter verwendet werden umso genauer kann die Messung oder Prüfung durchgeführt werden.

Zum Beispiel kann eine Merkmalsmatrix aufgestellt werden, in der die drei Parameter Resonanzfrequenz, Güte und Amplitude gegen unterschiedliche Materialien oder Schichtenfolgen einer Chipkarte 10 aufgetragen sind.

Das Messgerät 20 kann zum Beispiel eine Prüfvorrichtung zum Prüfen der Funktionsfähigkeit der Spule 16 für eine kontaktlos kommunizierende Chipkarte 10 sein oder eine derartige Prüfvorrichtung umfassen. Dazu umfasst das Messgerät 20 einen Impulsgeber 23. Dieser ist eingerichtet, den Referenz-Schwingkreis 17 über eine an den Impulsgeber 23 angeschlossene Erregerspule 24 kontaktlos anzuregen. Weiter umfasst die Messgerät 20 eine Messantenne 25, die wie die Erregerspule 24 in dem Messkopf 21 angeordnet sein kann.

Somit kann eine Prüfvorrichtung zum Prüfen der Funktionsfähigkeit der Spule 16 für die Materialprüfung der Chipkarte 10 eingesetzt werden. Dazu wird der Messkopf 21 mit dem Referenz-Schwingkreis 17 erweitert. Die zu messende Chipkarte 10 verändert dann den Schwingkreis 17, was dann gemessen wird. Der Messkopf 21 und der Referenz-Schwingkreis 17 formen gewissermaßen eine Messeinheit für die Chipkarte 10. Anders ausgedrückt wird der Referenz-Schwingkreis 17 als Sensor für die Chipkarte 10 verwendet. Der Referenz-Schwingkreis 17 kann Bestandteil einer weiteren hier nicht dargestellten Chipkarte sein. Dann wird diese weiteren hier nicht dargestellten Chipkarte als Sensor für die Chipkarte 10 verwendet.

Die Messantenne 25 ist eingerichtet, eine freie, gedämpfte Schwingung des Referenz-Schwingkreises 17 kontaktlos zu erfassen. Die Auswertungseinrichtung 22 ist mit der Messantenne 25 verbunden und eingerichtet, die von der Messantenne 25 erfasste freie, gedämpfte Schwingung auszuwerten.

Die Chipkarte 10 kann zur Messung auf einer Unterlage mit einer geringen Dielektrizitätszahl kleiner 10, vorzugsweise kleiner 5, angeordnet sein. So kann eine POM-Platte als Unterlage verwendet werden. Dieses Material hat eine sehr kleine Dielektrizitätszahl von etwa 4, die zudem konstant über die ganze Plattenoberfläche ist. Damit wird eine definierte Umgebung geschaffen, welche die Testqualität erhöht und verschiedene Testläufe vergleichbarer macht. Ebenso kann die Chipkarte 10 in Luft oder soweit wie möglich in Luft gelagert werden, zum Beispiel mittels dünner Bänder wie Angelschnüre. So kann die Dielektrizitätszahl hinter der Chipkarte 10 weiter gesenkt werden.

Die Messung oder die Materialprüfung kann ein Bewegen der Chipkarte 10 und/oder des Messkopfes 21 an einen einzelnen Messpunkt oder ein Bewegen oder Abfahren einer Bewegungsroute umfassen.

Statt einer kontinuierlichen Bewegungsroute können auch einzelne Messpunkte angefahren werden oder die Chipkarte 10 kann zum Beispiel bei der Herstellung an einem oder mehreren stationären Messköpfen vorbeigeführt werden. Im Fall von Messungen in kontinuierlichen zeitlichen Abständen werden gewissermaßen über den zeitlichen Abstand einzelne Messpunkte vorgegeben, die dann auf einer Bewegungsroute liegen können.

Der Referenz-Schwingkreis 17 kann zum Beispiel mittels mindestens einer Kapazität trimmbar sein. So können bei einer Messung unterschiedliche Frequenzbänder durchfahren werden. Dies erlaubt die Berücksichtigung frequenzabhängiger Merkmale der zu testenden Materialien.

Fig. 6 zeigt ein Flussdiagramm eines Verfahrens zur Materialprüfung eines kartenförmigen Datenträgers zum Beispiel in Form einer Chipkarte 10.

In einem ersten Schritt 100 erfolgt ein Anordnen des Referenz-Schwingkreises 17 an einem Messkopf 21 des Impuls-Messgeräts 20. Der Referenz-Schwingkreis 17 wird zum Beispiel als Bestandteil einer Referenz-Chipkarte definiert an dem Messkopf 21 befestigt, so dass eine eindeutige Lage zu dem Messkopf 21 erreicht wird.

Die Spule 16 des Referenz-Schwingkreises 17 und die Erregerspule 24 des Messkopfes 21 sind dabei parallel und überdeckend, vorzugsweise übereinanderliegend, das heißt vollständig überdeckend angeordnet. Der Referenz-Schwingkreis 17 und der Messkopf 21 sind derart zueinander angeordnet, dass ein Aussenden eines Impulses einer elektromagnetischen Schwingung von der Erregerspule 24 zu der Spule 16 möglich ist und dass ein Erfassen einer Schwingungsantwort der Spule 16 in Antwort auf den Impuls möglich ist.

In einem optionalen Schritt kann ein Kalibrieren erfolgen durch ein Aussenden eines Impulses, Erfassen einer Schwingungsantwort der Spule 16 beiziehungsweise des Referenz-Schwingkreises 17 in Antwort auf den Impuls und Bestimmen mindestens eines Kalibrierungsparameters Resonanzfrequenz, Güte und Amplitude aus der Schwingungsantwort. Die Güte der Spule 16 kann zum Beispiel aus einem Abklingkoeffizienten δ der Schwingungsantwort ermittelt werden. Je länger der Abklingvorgang dauert, desto höher ist die Güte des entsprechenden Schwingkreises. Somit erlaubt eine Auswertung der freien gedämpften Schwingung der Spule 16, das heißt deren Ausschwingen unmittelbar nach der Anregung, die Güte und auch die Eigenresonanzfrequenz der Spule 16 zu bestimmen. Die Amplitude kann zum Beispiel einfach als Maximalamplitude bestimmt werden.

Das Kalibrieren des Referenz-Schwingkreises 17 kann in freier Luft, das heißt ohne das Vorhandensein eines Materials in der Nähe des Messkopfes 21 erfolgen. Ebenso können bekannte Materialien, Datenträger oder Schichtfolgen von Materialien kalibriert werden. Dann werden diese Materialien usw. für eine Messung an dem Messkopf 21 angeordnet.

In einem zweiten Schritt 110 erfolgt ein relatives Bewegen des Referenz-Schwingkreises 17 zu mindestens einem Messpunkt auf der Chipkarte 10. Der Referenz-Schwingkreis 17 wird gemeinsam mit dem Messkopf 21 bewegt. Die Messung oder die Materialprüfung kann in einer Bewegungsroute über die Oberfläche der Chipkarte 10 oder rein punktuell erfolgen.

In einem dritten Schritt 120 erfolgt ein Aussenden eines Impulses, Erfassen einer Schwingungsantwort der Spule 16 in Antwort auf den Impuls und eines der Parameter Resonanzfrequenz, Güte und Amplitude aus der Schwingungsantwort. Dieser Schritt ist analog zu dem optionalen Schritt des Kalibrierens, wobei nun die im Bereich des Referenz-Schwingkreises 17 vorhandene Chipkarte 10 die Schwingungsantwort der Spule 16 verändert.

So ändert sich der Referenz-Schwingkreis 17 bei einem kapazitiven Einfluss durch Material im Bereich des Messkopfes 21. Wenn zum Beispiel eine zusätzliche Kapazität in den Schwingkreis 17 eingebracht wird sinkt die Frequenz signifikant und der Q-Faktor geringfügig.

Für jedes Material, jede Form von Datenträgern, Zwischenprodukten von Datenträgern oder Materialien kann anhand mindestens eines der Parameter Resonanzfrequenz, Güte und Amplitude eine Identifikation erstellt werden. Diese Zuordnung von Parameterwerten und Materialien oder Zusammensetzungen kann in einer Liste oder Matrix gespeichert werden.

In einem vierten Schritt 130 erfolgt ein Ermitteln von Material und/oder einer Zusammensetzung des Datenträgers, hier der Chipkarte 10, basierend auf mindestens einem der bestimmten Parameter. Dazu können zum Beispiel aktuelle Werte des oder der bestimmten Parameter mit einer Liste oder Matrix verglichen werden, in der eine Zuordnung von Parameterwerten und Materialien oder Zusammensetzungen gespeichert ist.

Ebenso ist es möglich, mehrere Messergebnisse mehrerer Messpunkte zu vergleichen, was eine relative Aussage erlaubt. Die Messpunkte können von einem oder mehreren Messobjekten stammen.

Darüber hinaus können von den einzelnen Parametern weitere Größen oder Subparameter wie zum Beispiel ein Maximalwert, Minimalwert und Durchschnittswert oder räumliche Verläufe der Parameter bestimmt werden. Diese Größen können zum Beispiel weiter für eine Identifikation von Materialien oder Zusammensetzungen verwendet werden.

## Patentansprüche

1. Verfahren zur Materialprüfung eines kartenförmigen Datenträgers (10), umfassend die Schritte:
- Anordnen (100) eines Referenz-Schwingkreises (17) aufweisend eine Spule (16) an einem Messkopf (21) eines Impuls-Messgeräts (20), das zum Aussenden eines Impulses einer elektromagnetischen Schwingung und zum Erfassen einer Schwingungsantwort der Spule (16) in Antwort auf den Impuls eingerichtet ist;
- Relatives Bewegen (120) des Referenz- Schwingkreises (17) zu dem Datenträger (10);
- Aussenden (130) eines Impulses, Erfassen einer Schwingungsantwort der Spule (16) in Antwort auf den Impuls und Bestimmen mindestens eines Parameters aus der Schwingungsantwort; und
- Ermitteln (140) von Material und/ oder einer Zusammensetzung des Datenträgers (10) basierend auf dem mindestens einen bestimmten Parameter.

2. Verfahren nach Anspruch 1, **dadurch gekennzeichnet, dass** ein Kalibrieren des Referenz- Schwingkreises (17) durch Aussenden eines Impulses, Erfassen einer Schwingungsantwort der Spule (16) in Antwort auf den Impuls und Bestimmen mindestens eines Kalibrierungsparameters aus der Schwingungsantwort vorgenommen wird und dass das Ermitteln des Materials und/oder der Zusammensetzung des Datenträgers (10) basierend auf dem mindestens einen bestimmten Parameter relativ zu mindestens einem Kalibrierungsparameter erfolgt.

3. Verfahren nach einem der Ansprüche 1 bis 2, **dadurch gekennzeichnet, dass** eine Güte der Spule (16) aus einem Abklingkoeffizienten (δ) der Schwingungsantwort ermittelt wird.

4. Verfahren nach einem der Ansprüche 1 bis 3, **dadurch gekennzeichnet, dass** das Aussenden und das Erfassen kontaktlos erfolgt.

5. Verfahren nach einem der Ansprüche 1 bis 4, **dadurch gekennzeichnet, dass** die Spule (16) Teil eines RFID-Transponders ist.

6. Verfahren nach einem der Ansprüche 1 bis 5, **dadurch gekennzeichnet, dass** der Referenz-Schwingkreis (17) die Spule (16), einen Kondensator (15) und einen Widerstand (19) aufweist.

7. Verfahren nach einem der Ansprüche 1 bis 6, **dadurch gekennzeichnet, dass** der Referenz-Schwingkreis (17) die Spule (16) und einen Kondensator (15) einer integrierten Schaltung des Datenträgers (10) aufweist.

8. Verfahren nach einem der Ansprüche 1 bis 7, **dadurch gekennzeichnet, dass** der mindestens eine Parameter aus der Gruppe Resonanzfrequenz, Güte, Amplitude und mittlerer Fehler gewählt wird.

## Claims

1. Method for material testing of a card-shaped data carrier (10), comprising the steps of:
- arranging (100) a reference resonant circuit (17) having a coil (16) on a measuring head (21) of a pulse measuring device (20) that is configured for emitting a pulse of an electromagnetic oscillation and for detecting an oscillation response of the coil (16) in response to the pulse;
- moving (120) the reference resonant circuit (17) relative to the data carrier (10);
- emitting (130) a pulse, detecting an oscillation response of the coil (16) in response to the pulse, and determining at least one parameter from the oscillation response; and
- ascertaining (140) material and/or a composition of the data carrier (10) based on the at least one determined parameter.

2. Method according to Claim 1, **characterized in that** the reference resonant circuit (17) is calibrated by emitting a pulse, an oscillation response of the coil (16) in response to the pulse is detected, and at least one calibration parameter is determined from the oscillation response, and **in that** the material and/or the composition of the data carrier (10) is ascertained based on the at least one determined parameter relative to at least one calibration parameter.

3. Method according to either of Claims 1 and 2, **characterized in that** the quality of the coil (16) is ascertained from a decay coefficient (δ) of the oscillation response.

4. Method according to one of Claims 1 to 3, **characterized in that** the emitting and the detecting are effected contactlessly.

5. Method according to one of Claims 1 to 4, **characterized in that** the coil (16) is part of an RFID transponder.

6. Method according to one of Claims 1 to 5, **characterized in that** the reference resonant circuit (17) includes the coil (16), a capacitor (15) and a resistor (19) .

7. Method according to one of Claims 1 to 6, **characterized in that** the reference resonant circuit (17) includes the coil (16) and a capacitor (15) of an integrated circuit of the data carrier (10).

8. Method according to one of Claims 1 to 7, **characterized in that** the at least one parameter is selected from the group consisting of resonant frequency, quality, amplitude and average error.

## Revendications

1. Procédé d'essai de matériau d'un support de données (10) sous forme de carte, comprenant les étapes consistant à :
- disposer (100) un circuit oscillant de référence (17) présentant une bobine (16) sur une tête de mesure (21) d'un appareil de mesure à impulsion (20) qui est conçu pour émettre une impulsion d'une oscillation électromagnétique et pour détecter une réponse en oscillation de la bobine (16) en réaction à l'impulsion ;
- déplacer (120) relativement le circuit oscillant de référence (17) par rapport au support de données (10) ;
- émettre (130) une impulsion, détecter une réponse en oscillation de la bobine (16) en réaction à l'impulsion, et déterminer au moins un paramètre à partir de la réponse en oscillation ; et
- établir (140) un matériau et/ou une composition du support de données (10) sur la base dudit au moins un paramètre déterminé.

2. Procédé selon la revendication 1, **caractérisé en ce qu'**un étalonnage du circuit oscillant de référence (17) est effectué par l'émission d'une impulsion, la détection d'une réponse en oscillation de la bobine (16) en réaction à l'impulsion, et la détermination d'au moins un paramètre d'étalonnage à partir de la réponse en oscillation, et **en ce que** l'établissement du matériau et/ou de la composition du support de données (10) est effectué sur la base dudit au moins un paramètre déterminé par rapport audit au moins un paramètre d'étalonnage.

3. Procédé selon l'une quelconque des revendications 1 à 2, **caractérisé en ce qu'**une qualité de la bobine (16) est établie à partir d'un coefficient d'évanouissement (δ) de la réponse en oscillation.

4. Procédé selon l'une quelconque des revendications 1 à 3, **caractérisé en ce que** l'émission et la détection sont effectuées sans contact.

5. Procédé selon l'une quelconque des revendications 1 à 4, **caractérisé en ce que** la bobine (16) fait partie d'un transpondeur RFID.

6. Procédé selon l'une quelconque des revendications 1 à 5, **caractérisé en ce que** le circuit oscillant de référence (17) présente la bobine (16), un condensateur (15) et une résistance (19).

7. Procédé selon l'une quelconque des revendications 1 à 6, **caractérisé en ce que** le circuit oscillant de référence (17) présente la bobine (16) et un condensateur (15) d'un circuit intégré du support de données (10).

8. Procédé selon l'une quelconque des revendications 1 à 7, **caractérisé en ce que** ledit au moins un paramètre est sélectionné dans le groupe de la fréquence de résonance, de la qualité, de l'amplitude et de l'erreur quadratique moyenne.
